# EUROPÄISCHE PATENTSCHRIFT

(11) **EP 2 267 801 B1**
(45) Veröffentlichungstag und Bekanntmachung des Hinweises auf die Patenterteilung: **27.05.2015**
(21) Anmeldenummer: 10184358.9
(22) Anmeldetag: 26.06.1997
(51) Int. Cl.: C09K 11/77, H01L 33/48, H01L 33/50, H01L 33/56

(54) **Licht abstrahlendes Halbleiterbauelement mit Lumineszenzkonversionselement**
Light-emitting semiconductor chip and light-emitting semiconductor component
Puce à semi-conducteur luminescente et composant à semi-conducteur luminescent

(30) Priorität: 26.06.1996 DE 19625622; 20.09.1996 DE 19638667
(43) Veröffentlichungstag der Anmeldung: 29.12.2010
(62) Teilanmeldung aus: 04008348.7
(73) Patentinhaber: OSRAM Opto Semiconductors GmbH, 93055 Regensburg (DE)
(72) Erfinder: Schneider, Jürgen, 79117, Freiburg (DE); Schmidt, Ralf, 79279, Vörstetten (DE); Schlotter, Peter, 79112, Freiburg (DE); Reeh, Ulrike, 80995, München (DE); Höhn, Klaus, 91301, Forchheim (DE); Stath, Norbert, 93049, Regensburg (DE); Waitl, Günter, 93049, Regensburg (DE)
(74) Vertreter: Epping - Hermann - Fischer

(56) Entgegenhaltungen:
- EP-A- 0 387 715
- EP-A1- 0 581 232
- DE-U1- 9 013 615
- JP-A- 5 152 609
- JP-A- 8 007 614
- US-A- 3 593 055
- US-A- 3 875 456

## Beschreibung

Die Erfindung bezieht sich auf ein Licht abstrahlendes Halbleiterbauelement nach dem Oberbegriff des Patentanspruches 1.

Ein derartiges Halbleiterbauelement ist beispielsweise aus der Offenlegungsschrift DE 38 04 293 bekannt. Darin ist eine Anordnung mit einer Elektrolumineszenz- oder Laserdiode beschrieben, bei der das gesamte von der Diode abgestrahlte Emmissionsspektrum mittels eines mit einem fluoreszierenden, Licht wandelnden organischen Farbstoff versetzten Elements aus Kunststoff zu größeren Wellenlängen hin verschoben wird. Das von der Anordnung abgestrahlte Licht weist dadurch eine andere Farbe auf als das von der Leuchtdiode ausgesandte. Abhängig von der Art des dem Kunststoff beigefügten Farbstoffes lassen sich mit ein und demselben Leuchtdiodentyp Leuchtdiodenanordnungen herstellen, die in unterschiedlichen Farben leuchten.

Aus DE-OS 2 347 289 ist eine Infrarot(IR)-Festkörperlampe bekannt, bei der an der Kante einer IR-Diode Leuchtstoff-Material angebracht ist, das die dort abgestrahlte IR-Strahlung in sichtbares Licht umwandelt. Ziel dieser Maßnahme ist es, zu Kontrollzwecken einen möglichst geringen Teil der von der Diode abgegebenen IR-Strahlung bei gleichzeitig möglichst geringer Verminderung der Intensität der abgegebenen IR-Strahlung in sichtbares Licht umzuwandeln. Weiterhin ist aus der EP 486 052 eine Licht emittierende Diode bekannt, bei der zwischen dem Substrat und einer aktiven elektrolumineszierenden Schicht mindestens eine Halbleiter-Photolumineszenzschicht angeordnet ist, die das von der aktiven Schicht in Richtung Substrat ausgesandte Licht eines ersten Wellenlängenbereichs in Licht eines zweiten Wellenlängenbereichs umwandelt, so dass die Licht emittierende Diode insgesamt Licht verschiedener Wellenlängenbereiche aussendet.

In vielen potentiellen Anwendungsgebieten für Leuchtdioden, wie zum Beispiel bei Anzeigeelementen im Kfz-Armaturenbrett, Beleuchtung in Flugzeugen und Autos und bei vollfarbtauglichen LED-Displays, tritt verstärkt die Forderung nach Leuchtdiodenanordnungen auf, mit denen sich mischfarbiges Licht, insbesondere weißes Licht erzeugen lässt.

In JP-07 176 794-A ist eine weißes Licht aussendende planare Lichtquelle beschrieben, bei der an einer Stirnseite einer transparenten Platte zwei blaues Licht emittierende Dioden angeordnet sind, die Licht in die transparente Platte hinein aussenden. Die transparente Platte ist auf einer der beiden einander gegenüberliegenden Hauptflächen mit einer fluoreszierenden Substanz beschichtet, die Licht emittiert, wenn sie mit dem blauen Licht der Dioden angeregt wird. Das von der fluoreszierenden Substanz emittierte Licht hat eine andere Wellenlänge als das von den Dioden emittierte blaue Licht. Bei diesem bekannten Bauelement ist es besonders schwierig, die fluoreszierende Substanz in einer Art und Weise aufzubringen, dass die Lichtquelle homogenes weißes Licht abstrahlt. Darüber hinaus bereitet auch die Reproduzierbarkeit in der Massenfertigung große Probleme, weil schon geringe Schichtdickenschwankungen der fluoreszierenden Schicht, zum Beispiel aufgrund von Unebenheiten der Oberfläche der transparenten Platte, eine Änderung des Weißtones des abgestrahlten Lichtes hervorruft.

Die Druckschrift JP 08-007614 A betrifft eine Hinterleuchtungseinrichung zur Erzeugung von weißem Licht für Displays, bei der blaues Licht emittierende Leuchtdioden an einem Lichtleiter angebracht sind, welcher mit einem organischen Leuchtstoff versehen ist.

In der Druckschrift DE 90 13 615 U ist eine Elektrolumineszenz- oder Laserdiode beschrieben, die einen organischen Farbstoff beinhaltet.

Aus der Druckschrift EP 0 387 715 A2 ist ein elektrolumineszierendes Element bekannt, das einen organischen Leuchtstoff umfasst.

Der vorliegenden Erfindung liegt die Aufgabe zugrunde, ein Halbleiterbauelement der eingangs genannten Art zu entwickeln, das homogenes mischfarbiges Licht abstrahlt und das eine technisch einfache Massenfertigung mit weitestgehend reproduzierbarer Bauelementcharakteristik gewährleistet.

Diese Aufgabe wird durch ein Halbleiterbauelement nach Anspruch 1 gelöst. Vorteilhafte Weiterbildungen der Erfindung sind Gegenstand der Unteransprüche. Ferner sind Verwendungsmöglichkeiten des erfindungsgemäßen Halbleiterbauelements angegeben.

Erfindungsgemäß ist vorgesehen, dass der strahlungsemittierende Halbleiterkörper eine Schichtenfolge, insbesondere eine Schichtenfolge mit einer aktiven Halbleiterschicht aus GaₓIn₁₋ₓN oder GaₓAl₁₋ₓN aufweist, die im Betrieb des Halbleiterbauelements eine elektromagnetische Strahlung eines ersten Wellenlängenbereiches aus dem ultravioletten, blauen und/oder grünen Spektralbereich aussendet. Das Lumineszenzkonversionselement wandelt einen Teil der aus dem ersten Wellenlängenbereich stammenden Strahlung in Strahlung eines zweiten Wellenlängenbereiches um, derart, dass das Halbleiterbauelement Mischstrahlung, insbesondere mischfarbiges Licht, bestehend aus Strahlung des ersten Wellenlängenbereiches und Strahlung des zweiten Wellenlängenbereiches, aussendet. Das heißt beispielsweise, dass das Lumineszenzkonversionselement einen Teil der vom Halbleiterkörper ausgesandten Strahlung bevorzugt nur über einen spektralen Teilbereich des ersten Wellenlängenbereichs spektral selektiv absorbiert und im längerwelligen Bereich (im zweiten Wellenlängenbereich) emittiert. Bevorzugt weist die von dem Halbleiterkörper ausgesandte Strahlung bei einer Wellenlänge λ ≤ 520 nm ein relatives Intensitätsmaximum auf und liegt der von dem Lumineszenzkonversionselement spektral selektiv absorbierte Wellenlängenbereich außerhalb dieses Intensitätsmaximums.

Ebenso kann vorteilhafterweise mit der Erfindung auch eine Anzahl (einer oder mehrerer) von aus dem ersten Wellenlängenbereich stammenden ersten spektralen Teilbereichen in mehrere zweite Wellenlängenbereiche umgewandelt werden. Dadurch ist es vorteilhafterweise möglich, vielfältige Farbmischungen und Farbtemperaturen zu erzeugen.

Das erfindungsgemäße Halbleiterbauelement hat den besonderen Vorteil, dass das über Lumineszenzkonversion erzeugte Wellenlängenspektrum und damit die Farbe des abgestrahlten Lichtes nicht von der Höhe der Betriebsstromstärke durch den Halbleiterkörper abhängt. Dies hat insbesondere dann große Bedeutung, wenn die Umgebungstemperatur des Halbleiterbauelementes und folglich bekanntermaßen auch die Betriebsstromstärke stark schwankt. Besonders Leuchtdioden mit einem Halbleiterkörper auf der Basis von GaN sind diesbezüglich sehr empfindlich.

Außerdem benötigt das erfindungsgemäße Halbleiterbauelement nur eine einzige Ansteuerspannung und damit auch nur eine einzige Ansteuerschaltungsanordnung, wodurch der Bauteileaufwand für die Ansteuerschaltung des Halbleiterbauelements sehr gering gehalten werden kann.

Gemäß der Erfindung ist als Lumineszenzkonversionselement über dem Halbleiterkörper eine teiltransparente, das heißt eine für die von dem Strahlung aussendenden Halbleiterkörper ausgesandte Strahlung teilweise transparente Lumineszenzkonversionsschicht vorgesehen. Um eine einheitliche Farbe des abstrahlten Lichtes sicherzustellen, ist vorteilhafterweise die Lumineszenzkonversionsschicht derart ausgebildet, dass sie durchweg eine konstante Dicke aufweist. Dies hat den besonderen Vorteil, dass die Weglänge des von dem Halbleiterkörper abgestrahlten Lichtes durch die Lumineszenzkonversionsschicht hindurch für alle Strahlungsrichtungen nahezu konstant ist. Dadurch kann erreicht werden, dass das Halbleiterbauelement in alle Richtungen Licht derselben Farbe abstrahlt. Ein weiterer besonderer Vorteil eines erfindungsgemäßen Halbleiterbauelements gemäß dieser Weiterbildung besteht darin, dass auf einfache Weise eine hohe Reproduzierbarkeit erzielt werden kann, was für eine effiziente Massenfertigung von wesentlicher Bedeutung ist. Als Lumineszenzkonversionsschicht kann beispielsweise eine mit Leuchtstoff versetzte Lack- oder Harzschicht vorgesehen sein.

In einer nicht erfindungsgemäßen Abwandlung weist das Halbleiterbauelement als Lumineszenzkonversionselement eine teiltransparente Lumineszenzkonversionsumhüllung auf, die zumindest einen Teil des Halbleiterkörpers (und eventuell Teilbereiche der elektrischen Anschlüsse) umschließt und gleichzeitig als Bauteilumhüllung (Gehäuse) genutzt sein kann. Der Vorteil eines Halbleiterbauelements gemäß dieser Abwandlung besteht im Wesentlichen darin, dass zu seiner Herstellung konventionelle, für die Herstellung von herkömmlichen Leuchtdioden (zum Beispiel Radial-Leuchtdioden) eingesetzte Produktionslinien genutzt werden können. Für die Bauteilumhüllung ist anstelle des bei herkömmlichen Leuchtdioden dafür verwendeten transparenten Kunststoffes das Material der Lumineszenzkonversionsumhüllung verwendet.

Bei weiteren vorteilhaften Ausführungsformen des erfindungsgemäßen Halbleiterbauelements besteht die Lumineszenzkonversionsschicht aus einem transparenten Material, zum Beispiel Kunststoff, bevorzugt Epoxidharz, das mit mindestens einem Leuchtstoff versehen ist (Beispiele für bevorzugte Kunststoffe und Leuchtstoffe finden sich weiter unten). Auf diese Weise lassen sich Lumineszenzkonversionselemente besonders kostengünstig herstellen. Die dazu notwendigen Verfahrensschritte sind nämlich ohne großen Aufwand in herkömmliche Produktionslinien für Leuchtdioden integrierbar.

Bei einer besonders bevorzugten Weiterbildung der Erfindung ist vorgesehen, dass der oder die zweiten Wellenlängenbereiche im Wesentlichen größere Wellenlängen aufweisen als der erste Wellenlängenbereich.

Insbesondere ist vorgesehen, dass ein zweiter spektraler Teilbereich des ersten Wellenlängenbereiches und ein zweiter Wellenlängenbereich zueinander komplementär sind. Auf diese Weise kann aus einer einzigen farbigen Lichtquelle, insbesondere einer Leuchtdiode mit einem einzigen blaues Licht abstrahlenden Halbleiterkörper, mischfarbiges, insbesondere weißes Licht erzeugt werden. Um zum Beispiel mit einem blaues Licht aussendenden Halbleiterkörper weißes Licht zu erzeugen, wird ein Teil der von dem Halbleiterkörper ausgesandten Strahlung aus dem blauen Spektralbereich in den zu Blau komplementärfarbigen gelben Spektralbereich konvertiert. Die Farbtemperatur oder Farbort des weißen Lichtes kann dabei durch geeignete Wahl des Lumineszenzkonversionselementes, insbesondere durch eine geeignete Wahl des Leuchtstoffes, dessen Partikelgröße und dessen Konzentration, variiert werden. Darüber hinaus bieten diese Anordnungen vorteilhafterweise auch die Möglichkeit, Leuchtstoffmischungen einzusetzen, wodurch sich vorteilhafterweise der gewünschte Farbton sehr genau einstellen lässt. Ebenso können Lumineszenzkonversionselemente inhomogen ausgestaltet sein, zum Beispiel mittels einer inhomogenen Leuchtstoffverteilung. Unterschiedliche Weglängen des Lichtes durch das Lumineszenzkonversionselement können dadurch vorteilhafterweise kompensiert werden.

Bei einer weiteren bevorzugten Ausführungsform des erfindungsgemäßen Halbleiterbauelements weist das Lumineszenzkonversionselement oder ein anderer Bestandteil einer Bauteilumhüllung zur Farbanpassung einen oder mehrere Farbstoffe auf, die keine Wellenlängenkonversion bewirken. Hierzu können die für die Herstellung von herkömmlichen Leuchtdioden verwendeten Farbstoffe wie zum Beispiel Azo-, Anthrachinon- oder Perinon-Farbstoffe eingesetzt werden.

Bei dem erfindungsgemäßen Halbleiterbauelement ist zumindest ein Teil der Oberfläche des Halbleiterkörpers von einer ersten, zum Beispiel aus einem Kunststoff bestehenden transparenten Hülle umgeben, auf der die Lumineszenzkonversionsschicht aufgebracht ist. Dadurch wird die Strahlungsdichte im Lumineszenzkonversionselement und somit dessen Strahlungsbelastung verringert, was sich je nach verwendeten Materialien positiv auf die Lebensdauer des Lumineszenzkonversionselementes auswirkt.

Bei einer besonders bevorzugten Ausgestaltung der Erfindung sowie der oben genannten Ausführungsformen ist ein strahlungsemittierender Halbleiterkörper verwendet, bei dem das ausgesandte Strahlungsspektrum bei einer Wellenlänge zwischen 420 nm und 460 nm, insbesondere bei 430 nm (zum Beispiel Halbleiterkörper auf der Basis von GaₓAl₁₋ₓN) oder 450 nm (zum Beispiel Halbleiterkörper auf der Basis von GaₓIn₁₋ₓN) ein Intensitätsmaximum aufweist. Mit einem derartigen erfindungsgemäßen Halbleiterbauelement lassen sich vorteilhafterweise nahezu sämtliche Farben und Mischfarben der CIE-Farbtafel erzeugen. Der strahlungsemittierende Halbleiterkörper kann hierbei, wie oben angegeben, im Wesentlichen aus elektrolumineszierendem Halbleitermaterial aber auch aus einem anderen elektrolumineszierenden Material, wie beispielsweise Polymermaterial, bestehen.

Bei einer weiteren besonders bevorzugten Weiterbildung der Erfindung und deren Ausführungsformen ist die Lumineszenzkonversionsschicht aus einem Lack oder aus einem Kunststoff hergestellt, beispielsweise aus einem für die Umhüllung optoelektronischer Bauelemente eingesetzten Silikon-, Thermoplast- oder Duroplastmaterial (Epoxid- und Acrylatharze). Des Weiteren können zum Beispiel aus Thermoplastmaterialien gefertigte Abdeckelemente als Lumineszenzkonversionsumhüllung eingesetzt sein. Sämtliche oben genannten Materialien lassen sich auf einfache Weise mit einem oder mehreren Leuchtstoffen versetzen.

Es lässt sich eine nicht erfindungsgemäße Abwandlung des Halbleiterbauelements realisieren, wenn der Halbleiterkörper in einer Ausnehmung eines gegebenenfalls vorgefertigten Gehäuses angeordnet ist und die Ausnehmung mit einem die Lumineszenzkonversionsschicht aufweisenden Abdeckelement versehen ist. Ein derartiges Halbleiterbauelement lässt sich in großer Stückzahl in herkömmlichen Produktionslinien herstellen. Hierzu muss lediglich nach der Montage des Halbleiterkörpers in das Gehäuse das Abdeckelement, beispielsweise eine Lack- oder Gießharzschicht oder eine vorgefertigtes Abdeckplatte aus Thermoplastmaterial, auf das Gehäuse aufgebracht werden. Optional kann die Ausnehmung des Gehäuses mit einem transparenten Material, beispielsweise einem transparenten Kunststoff, gefüllt sein, das insbesondere die Wellenlänge des von dem Halbleiterkörper ausgesandten Lichtes nicht verändert oder aber, falls gewünscht, bereits lumineszenzkonvertierend ausgebildet sein kann.

Bei einer nicht erfindungsgemäßen Abwandlung des Halbleiterbauelements ist der Halbleiterkörper in einer Ausnehmung eines gegebenenfalls vorgefertigten eventuell bereits mit einem Leadframe versehenen Gehäuse angeordnet und ist die Ausnehmung mit einem zumindest teiltransparenten Gießharz gefüllt, dem der Leuchtstoff bereits vor dem Ausgießen der Ausnehmung zugefügt ist. Das Lumineszenzkonversionselement ist hier somit von dem mit Leuchtstoff versehenen Verguss des Halbleiterkörpers versehen.

Ein besonders bevorzugtes Material zur Herstellung des Lumineszenzkonversionselements ist Epoxidharz, dem ein oder mehrere Leuchtstoffe zugesetzt sind. Anstelle von Epoxidharz kann aber auch Polymethylmetacrylat (PMMA) verwendet sein.

PMMA lässt sich auf einfache Weise mit organischen Farbstoffmolekülen versetzen. Zur Herstellung von grün, gelb und rot leuchtenden erfindungsgemäßen Halbleiterbauelementen können zum Beispiel Farbstoffmoleküle auf Perylen-Basis verwendet sein. Im UV, im Sichtbaren oder im Infraroten leuchtende Halbleiterbauelemente können auch durch Beimischung von 4f-metallorganischen Verbindungen hergestellt werden. Insbesondere können rot leuchtende erfindungsgemäße Halbleiterbauelemente zum Beispiel durch Beimischung von auf Eu³⁺ basierenden metallorganischen Chelaten (λ ≈ 620 nm) realisiert werden. Infrarot strahlende erfindungsgemäße Halbleiterbauelemente, insbesondere mit blaues Licht aussendenden Halbleiterkörpern, können mittels Beimischung von 4f-Chelaten oder von Ti³⁺-dotiertem Saphir hergestellt werden.

Ein weißes Licht abstrahlendes erfindungsgemäßes Halbleiterbauelement lässt sich vorteilhafterweise dadurch herstellen, dass der Leuchtstoff so gewählt wird, dass eine von dem Halbleiterkörper ausgesandte blaue Strahlung in komplementäre Wellenlängenbereiche, insbesondere Blau und Gelb, oder zu additiven Farbtripeln, zum Beispiel Blau, Grün und Rot umgewandelt wird. Hierbei wird das gelbe beziehungsweise das grüne und rote Licht über die Leuchtstoffe erzeugt. Der Farbton (Farbort in der CIE-Farbtafel) des dadurch erzeugten weißen Lichts kann dabei durch geeignete Wahl des/der Farbstoffes/e hinsichtlich Mischung und Konzentration variiert werden.

Geeignete organische Leuchtstoffe für ein weißes Licht abstrahlendes Halbleiterbauelement sind Perylen-Leuchtstoffe wie zum Beispiel BASF Lumogen F 083 für grüne Lumineszenz, BASF Lumogen F 240 für gelbe Lumineszenz und BASF Lumogen F 300 für rote Lumineszenz. Diese Farbstoffe lassen sich auf einfache Weise zum Beispiel transparentem Epoxidharz, zusetzen.

Eine bevorzugte Methode, mit einem blaues Licht abstrahlenden Halbleiterkörper ein grün leuchtendes Halbleiterbauelement herzustellen, besteht darin, für das Lumineszenzkonversionselement UO₂⁺⁺-substituiertes Borsilikatglas zu verwenden.

Bei einer weiteren bevorzugten Weiterbildung eines erfindungsgemäßen Halbleiterbauelements beziehungsweise der oben angegebenen vorteilhaften Ausführungsformen sind dem Lumineszenzkonversionselement oder einer anderen strahlungsdurchlässigen Komponente der Bauteilumhüllung zusätzlich Licht streuende Partikel, so genannte Diffusoren, zugesetzt. Hierdurch lässt sich vorteilhafterweise der Farbeindruck und die Abstrahlcharakteristik des Halbleiterbauelements optimieren.

Erfindungsgemäß enthält das Lumineszenzkonversionselement anorganische Leuchtstoffpartikel. Bei einer besonders vorteilhaften Ausführungsform des erfindungsgemäßen Halbleiterbauelements besteht das

Lumineszenzkonversionselement zumindest teilweise aus einem transparenten Epoxidharz, das mit einem anorganischen Leuchtstoff versehen ist. Vorteilhafterweise lassen sich nämlich anorganische Leuchtstoffe auf einfache Weise in Epoxidharz einbinden. Ein besonders bevorzugter anorganischer Leuchtstoff zur Herstellung von weiß leuchtenden erfindungsgemäßen Halbleiterbauelementen ist der Phosphor YAG:Ce (Y₃Al₅O₁₂:Ce³⁺). Dieser lässt sich auf besonders einfache Weise in herkömmlich in der LED-Technik verwendeten transparenten Epoxidharzen mischen. Weiterhin als Leuchtstoffe denkbar sind weitere mit seltenen Erden dotierte Granate wie zum Beispiel Y₃Ga₅O₁₂:Ce³⁺, Y(Al,Ga)₅O₁₂:Ce³⁺ und Y(Al,Ga)₅O₁₂:Tb³⁺ sowie mit seltenen Erden dotierte Erdalkali-Sulfide wie zum Beispiel SrS:Ce³⁺,Na, SrS:Ce³⁺,Cl, SrS:CeCl₃, CaS:Ce³⁺ und SrSe:Ce³⁺.

Zur Erzeugung von verschiedenartig mischfarbigem Licht eignen sich darüber hinaus besonders die mit seltenen Erden dotierten Thiogallate wie zum Beispiel CaGa₂S₄:Ce³⁺ und SrGa₂S₄:Ce³⁺. Ebenso ist hierzu die Verwendung von mit seltenen Erden dotierten Aluminaten wie zum Beispiel YAlO₃:Ce³⁺, YGaO₃:Ce³⁺, Y(Al, Ga)O₃:Ce³⁺ und mit seltenen Erden dotierten Orthosilikaten M₂SiO₅:Ce³⁺ (M: Sc, Y, Sc) wie zum Beispiel Y₂SiO₅:Ce³⁺ denkbar. Bei allen Yttriumverbindungen kann das Yttrium im Prinzip auch durch Scandium oder Lanthan ersetzt werden.

Bei einer weiteren möglichen Ausführungsform des erfindungsgemäßen Halbleiterbauelements bestehen zumindest alle Licht durchstrahlten Komponenten der Umhüllung, das heißt auch die Lumineszenzkonversionsumhüllung beziehungsweise -schicht aus rein anorganischen Materialien. Das Lumineszenzkonversionselement besteht somit aus einem anorganischen Leuchtstoff, der in einem temperaturstabilen, transparenten oder teiltransparenten anorganischen Material eingebettet ist. Insbesondere besteht das Lumineszenzkonversionselement aus einem anorganischen Phosphor, der in ein vorteilhafterweise niedrig schmelzendes anorganisches Glas (zum Beispiel Silikatglas) eingebettet ist. Eine bevorzugte Herstellungsweise für eine derartige Lumineszenzkonversionsschicht ist die Sol-Gel-Technik, mit der die gesamte Lumineszenzkonversionsschicht, das heißt sowohl der anorganische Leuchtstoff als auch das Einbettmaterial in einem Arbeitsgang hergestellt werden kann.

Um die Durchmischung der von dem Halbleiterkörper ausgesandten Strahlung des ersten Wellenlängenbereiches mit der lumineszenzkonvertierten Strahlung des zweiten Wellenlängebereiches und damit die Farbhomogenität des abstrahlten Lichtes zu verbessern, ist bei einer vorteilhaften Ausgestaltung des erfindungsgemäßen Halbleiterbauelements der Lumineszenzumhüllung beziehungsweise der Lumineszenzkonversionsschicht und/oder einer anderen Komponente der Bauteilumhüllung zusätzlich ein im Blauen lumineszierender Farbstoff zugefügt, der eine so genannte Richtcharakteristik der von dem Halbleiterkörper abgestrahlten Strahlung abschwächt. Unter Richtcharakteristik ist zu verstehen, dass die von dem Halbleiterkörper ausgesandte Strahlung eine bevorzugte Abstrahlrichtung aufweist.

Bei dem erfindungsgemäßen Halbleiterbauelement ist zum oben genannten Zweck der Durchmischung der ausgesandten Strahlung der anorganische Leuchtstoff in Pulverform verwendet, wobei sich die Leuchtstoffpartikel in dem sie umhüllenden Stoff (Matrix) nicht lösen. Außerdem weisen der anorganische Leuchtstoff und der ihn umhüllende Stoff voneinander verschiedene Brechungsindizes auf. Dies führt vorteilhafterweise dazu, dass abhängig von der Korngröße des Leuchtstoffes, ein Anteil des nicht vom Leuchtstoff absorbierten Lichtes gestreut wird. Dadurch ist die Richtcharakteristik der von dem Halbleiterkörper abgestrahlten Strahlung effizient geschwächt, so dass die nicht absorbierte Strahlung und die lumineszenzkonvertierte Strahlung homogen gemischt werden, was zu einem räumlich homogenen Farbeindruck führt.

Ein weißes Licht abstrahlendes erfindungsgemäßes Halbleiterbauelement lässt sich besonders bevorzugt dadurch realisieren, dass einem zur Herstellung der Lumineszenzkonversionsschicht verwendeten Epoxidharz der anorganische Leuchtstoff YAG:Ce (Y₃Al₅O₁₂:Ce³⁺) beigemischt ist. Ein Teil einer von dem Halbleiterkörper ausgesandten blauen Strahlung wird von dem anorganischen Leuchtstoff Y₃Al₅O₁₂:Ce³⁺ in den gelben Spektralbereich und somit in einen zur Farbe Blau komplementärfarbigen Wellenlängenbereich verschoben. Der Farbton (Farbort in der CIE-Farbtafel) des weißen Lichts kann dabei durch geeignete Wahl der Farbstoffmischung und -konzentration variiert werden.

Der anorganische Leuchtstoff YAG:Ce hat unter anderem den besonderen Vorteil, dass es sich hierbei um nicht lösliche Farbpigmente (Partikelgröße im Bereich von 10 µm) mit einem Brechungsindex von zirka 1,84 handelt. Dadurch tritt neben der Wellenlängenkonversion noch ein Streueffekt auf, der zu einer guten Vermischung von blauer Diodenstrahlung und gelber Konverterstrahlung führt.

Bei einer weiteren bevorzugten Weiterbildung eines erfindungsgemäßen Halbleiterbauelements beziehungsweise der oben angegebenen vorteilhaften Ausführungsformen sind dem Lumineszenzkonversionselement oder einer anderen strahlungsdurchlässigen Komponente der Bauteilumhüllung zusätzlich Licht streuende Partikel, so genannte Diffusoren, zugesetzt. Hierdurch lässt sich vorteilhafterweise der Farbeindruck und die Abstrahlcharakteristik des Halbleiterbauelements weiter optimieren.

Von besonderem Vorteil ist, dass die Leuchteffizienz von weiß leuchtenden erfindungsgemäßen Halbleiterbauelementen beziehungsweise deren oben genannten Ausführungsformen mit einem im Wesentlichen auf der Basis von GaN hergestellten blau leuchtenden Halbleiterkörper vergleichbar ist mit der Leuchteffizienz einer Glühbirne. Der Grund dafür besteht darin, dass zum einen die externe Quantenausbeute derartiger Halbleiterkörper bei einigen Prozent liegt und andererseits die Lumineszenzausbeute von organischen Farbstoff-Molekülen oft bei über 90 % angesiedelt ist. Darüber hinaus zeichnet sich das erfindungsgemäße Halbleiterbauelement im Vergleich zur Glühbirne durch eine extrem lange Lebensdauer, größere Robustheit und eine kleinere Betriebsspannung aus.

Vorteilhaft ist weiterhin, dass die für das menschliche Auge wahrnehmbare Helligkeit des erfindungsgemäßen Halbleiterbauelements gegenüber einem ohne Lumineszenzkonversionselement ausgestatteten, aber sonst identischen Halbleiterbauelement deutlich erhöht werden kann, da die Augenempfindlichkeit zu höherer Wellenlänge hin zunimmt.

Darüber hinaus kann mit dem erfindungsgemäßen Prinzip vorteilhafterweise auch eine von dem Halbleiterkörper neben der sichtbaren Strahlung ausgesandte ultraviolette Strahlung in sichtbares Licht umgewandelt werden. Dadurch wird die Helligkeit des vom Halbleiterkörper ausgesandten Lichts deutlich erhöht.

Das hier vorgestellte Konzept der Lumineszenzkonversion mit blauem Licht eines Halbleiterkörpers lässt sich vorteilhafterweise auch auf mehrstufige Lumineszenzkonversionselemente erweitern, nach dem Schema ultraviolett → blau → grün → gelb → rot. Hierbei wird eine Mehrzahl von spektral selektiv emittierenden Lumineszenzkonversionselementen relativ zum Halbleiterkörper hintereinander angeordnet.

Ebenso können vorteilhafterweise mehrere unterschiedlich spektral selektiv emittierende Farbstoffmoleküle gemeinsam in einen transparenten Kunststoff eines Lumineszenzkonversionselements eingebettet sein. Hierdurch ist ein sehr breites Farbenspektrum erzeugbar.

Ein besonderer Vorteil von erfindungsgemäßen weißes Licht abstrahlenden Halbleiterbauelementen, bei denen als Lumineszenzkonversionsfarbstoff insbesondere YAG:Ce verwendet ist, besteht darin, dass dieser Leuchtstoff bei Anregung mit blauem Licht eine spektrale Verschiebung von zirka 100 nm zwischen Absorption und Emission bewirkt. Dies führt zu einer wesentlichen Reduktion der Reabsorption des vom Leuchtstoff emittierten Lichtes und damit zu einer höheren Lichtausbeute. Außerdem besitzt YAG:Ce vorteilhafterweise eine hohe thermische und photochemische (zum Beispiel UV-) Stabilität (wesentlich höher als organische Leuchtstoffe), so dass auch weiß leuchtende Dioden für Außenanwendung und/oder hohe Temperaturbereiche herstellbar sind.

YAG:Ce hat sich bislang hinsichtlich Reabsorption, Lichtausbeute, thermischer und photochemischer Stabilität und Verarbeitbarkeit als am besten geeigneter Leuchtstoff herausgestellt. Denkbar ist jedoch auch die Verwendung von anderen Ce-dotierten Phosphoren, insbesondere Ce-dotierten Granaten.

Besonders vorteilhaft lassen sich erfindungsgemäße Halbleiterbauelemente insbesondere aufgrund ihrer geringen Leistungsaufnahme in vollfarbtauglichen LED-Displays, zur Beleuchtung von Kfz-Innenräumen oder von Flugzeugkabinen sowie zur Beleuchtung von Anzeigevorrichtungen wie Kfz-Armaturen oder Flüssigkristallanzeigen verwenden.

Weitere Merkmale, Vorteile und Zweckmäßigkeiten der Erfindung ergeben sich aus der nachfolgenden Beschreibung von Ausführungsbeispielen in Verbindung mit den Figuren. Es zeigen:
- Figur 1: eine schematische Schnittansicht einer Abwandlung eines nicht erfindungsgemäßen Halbleiterbauelements;
- Figur 2: eine schematische Schnittansicht eines Ausführungsbeispiels eines erfindungsgemäßen Halbleiterbauelementes;
- Figur 3: eine schematische Schnittansicht durch ein Ausführungsbeispiel eines erfindungsgemäße Halbleiterbauelementes;
- Figur 4: eine schematische Schnittansicht eines Ausführungsbeispiels eines erfindungsgemäßen Halbleiterbauelements;
- Figur 5: eine schematische Schnittansicht einer Abwandlung eines nicht erfindungsgemäßen Halbleiterbauelementes;
- Figur 6: eine schematische Schnittansicht einer Abwandlung eines nicht erfindungsgemäßen Halbleiterbauelementes;
- Figur 7: eine schematische Darstellung eines Emissionsspektrums eines blaues Licht abstrahlenden Halbleiterkörpers mit einer Schichtenfolge auf der Basis von GaN;
- Figur 8: eine schematische Darstellung der Emissionsspektren zweier erfindungsgemäßer Halbleiterbauelemente, die weißes Licht abstrahlen;
- Figur 9: eine schematische Schnittdarstellung durch einen Halbleiterkörper, der blaues Licht aussendet;
- Figur 10: eine schematische Schnittansicht einer Abwandlung eines nicht erfindungsgemäßen Halbleiterbauelementes;
- Figur 11: eine schematische Darstellung eines Emissionsspektrums eines erfindungsgemäßen Halbleiterbauelementes, das mischfarbiges rotes Licht abstrahlt;
- Figur 12: eine schematische Darstellung der Emissionsspektren von weiteren erfindungsgemäßen Halbleiterbauelementen, die weißes Licht abstrahlen;
- Figur 13: eine schematische Schnittansicht einer Abwandlung eines nicht erfindungsgemäßen Halbleiterbauelementes und
- Figur 14: eine schematische Schnittansicht eines Ausführungsbeispiels eines erfindungsgemäßen Halbleiterbauelementes.

In den verschiedenen Figuren sind gleiche beziehungsweise gleich wirkende Teile immer mit denselben Bezugszeichen bezeichnet.

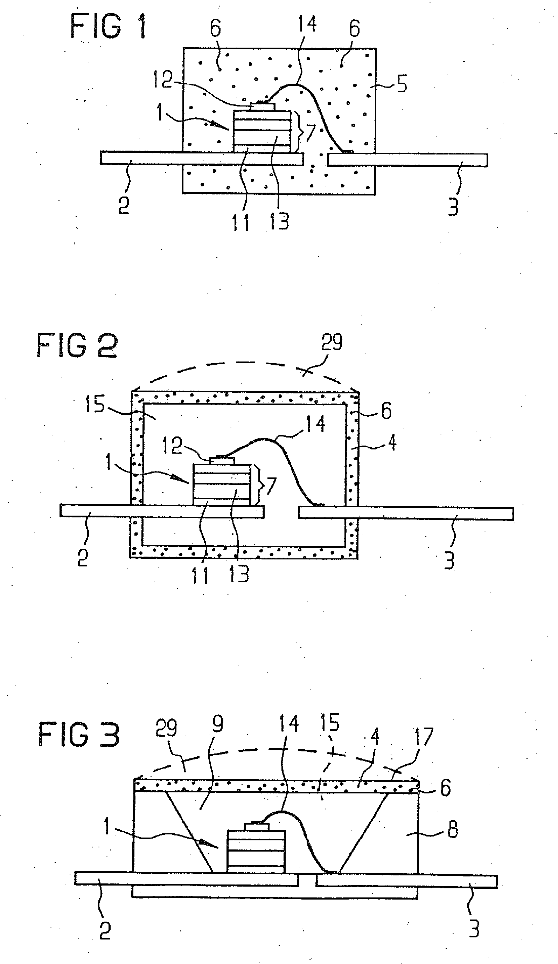

Bei dem in Figur 1 dargestellten Licht aussendenden Halbleiterbauelement weist ein Halbleiterkörper 1 einen Rückseitenkontakt 11, einen Vorderseitenkontakt 12 und eine sich aus einer Anzahl von unterschiedlichen Schichten zusammensetzende Schichtenfolge 7 auf, die im Betrieb des Halbleiterbauelements mindestens eine eine Strahlung (zum Beispiel ultraviolett, blau oder grün) aussendende aktive Zone besitzt.

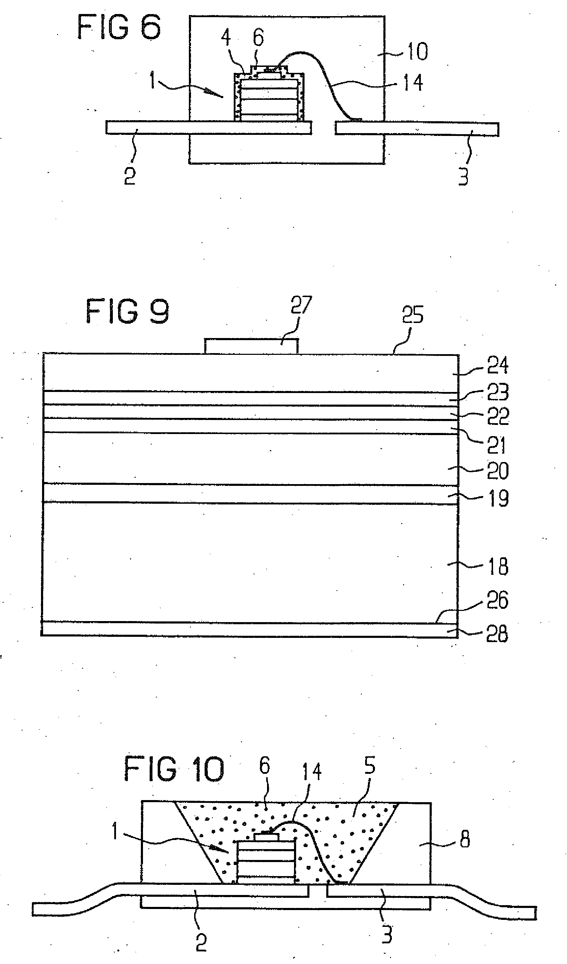

Ein Beispiel für eine geeignete Schichtenfolge 7 für dieses und für sämtliche im Folgenden beschriebenen Ausführungsbeispiele ist in Figur 9 gezeigt. Hierbei ist auf einem Substrat 18, das zum Beispiel aus SiC besteht, eine Schichtenfolge aus einer AlN- oder GaN-Schicht 19, einer n-leitenden GaN-Schicht 20, einer n-leitenden GaₓAl₁₋ₓN- oder GaₓIn₁₋ₓN-Schicht 21, einer weiteren n-leitenden GaN- oder einer GaₓIn₁₋ₓN-Schicht 22, einer p-leitenden GaₓAl₁₋ₓN- oder GaₓIn₁₋ₓN-Schicht 23 und einer p-leitenden GaN-Schicht 24 aufgebracht. Auf einer Hauptfläche 25 der p-leitenden GaN-Schicht 24 und einer Hauptfläche 26 des Substrats 18 ist jeweils eine Kontaktmetallisierung 27, 28 aufgebracht, die aus einem herkömmlich in der Opto-Halbleitertechnik für elektrische Kontakte verwendeten Werkstoff besteht.

Es kann jedoch auch jeder andere dem Fachmann für das erfindungsgemäße Halbleiterbauelement als geeignet erscheinende Halbleiterkörper verwendet werden. Dies gilt ebenso für sämtliche nachfolgend beschriebenen Ausführungsbeispiele.

In der Abwandlung von Figur 1 ist der Halbleiterkörper 1 mittels eines elektrisch leitenden Verbindungsmittels, zum Beispiel ein metallisches Lot oder ein Klebstoff, mit seinem Rückseitenkontakt 11 auf einem ersten elektrischen Anschluss 2 befestigt. Der Vorderseitenkontakt 12 ist mittels eines Bonddrahtes 14 mit einem zweiten elektrischen Anschluss 3 verbunden.

Die freien Oberflächen des Halbleiterkörpers 1 und Teilbereiche der elektrischen Anschlüsse 2 und 3 sind unmittelbar von einer Lumineszenzkonversionsumhüllung 5 umschlossen. Diese besteht bevorzugt aus einem für transparente Leuchtdiodenumhüllungen verwendbaren transparenten Kunststoff (bevorzugt Epoxidharz oder auch Polymethylmetaacrylat), der mit Leuchtstoff 6, bevorzugt anorganischer Leuchtstoff, für weiß leuchtende Bauelemente bevorzugt Y₃Al₅O₁₂:Ce³⁺ (YAG:Ce), versetzt ist.

Das in Figur 2 dargestellte Ausführungsbeispiel eines erfindungsgemäßen Halbleiterbauelements unterscheidet sich von dem der Figur 1 dadurch, dass der Halbleiterkörper 1 und Teilbereiche der elektrischen Anschlüsse 2 und 3 anstatt von einer Lumineszenzkonversionsumhüllung von einer transparenten Umhüllung 15 umschlossen sind. Diese transparente Umhüllung 15 bewirkt keine Wellenlängenänderung der von dem Halbleiterkörper 1 ausgesandten Strahlung und besteht beispielsweise aus einem in der Leuchtdiodentechnik herkömmlich verwendeten Epoxid-, Silikon- oder Acrylatharz oder aus einem anderen geeigneten strahlungsdurchlässigen Material wie zum Beispiel anorganisches Glas.

Auf diese transparente Umhüllung 15 ist eine Lumineszenzkonversionsschicht 4 aufgebracht, die, wie in der Figur 2 dargestellt, die gesamte Oberfläche der Umhüllung 15 bedeckt. Ebenso denkbar ist, dass die Lumineszenzkonversionsschicht 4 nur einen Teilbereich dieser Oberfläche bedeckt. Die Lumineszenzkonversionsschicht 4 besteht beispielsweise wiederum aus einem transparenten Kunststoff (zum Beispiel Epoxidharz, Lack oder Polymethylmetaacrylat), der mit einem Leuchtstoff 6 versetzt ist. Auch hier eignet sich als Leuchtstoff für ein weiß leuchtendes Halbleiterbauelement bevorzugt YAG:Ce.

Dieses Ausführungsbeispiel hat den besonderen Vorteil, dass für die gesamte von dem Halbleiterkörper ausgesandte Strahlung die Weglänge durch das Lumineszenzkonversionselement näherungsweise gleich groß ist. Dies spielt insbesondere dann eine bedeutende Rolle, wenn, wie oftmals der Fall, der genaue Farbton des von dem Halbleiterbauelement abgestrahlten Lichtes von dieser Weglänge abhängt.

Zur besseren Auskopplung des Lichtes aus der Lumineszenzkonversionsschicht 4 von Figur 2 kann auf einer Seitenfläche des Bauelements eine linsenförmige Abdeckung 29 (gestrichelt eingezeichnet) vorgesehen sein, die eine Totalreflexion der Strahlung innerhalb der Lumineszenzkonversionsschicht 4 reduziert. Diese linsenförmige Abdeckung 29 kann aus transparentem Kunststoff oder Glas bestehen und auf die Lumineszenzkonversionsschicht 4 beispielsweise aufgeklebt oder direkt als Bestandteil der Lumineszenzkonversionsschicht 4 ausgebildet sein.

Bei dem in Figur 3 dargestellten Ausführungsbeispiel sind der erste und zweite elektrische Anschluss 2, 3 in ein lichtundurchlässiges, eventuell vorgefertigtes Grundgehäuse 8 mit einer Ausnehmung 9 eingebettet. Unter "vorgefertigt" ist zu verstehen, dass das Grundgehäuse 8 bereits an den Anschlüssen 2, 3 beispielsweise mittels Spritzguss fertig ausgebildet ist, bevor der Halbleiterkörper auf den Anschluss 2 montiert wird. Das Grundgehäuse 8 besteht beispielsweise aus einem lichtundurchlässigen Kunststoff und die Ausnehmung 9 ist hinsichtlich ihrer Form als Reflektor 17 für die vom Halbleiterkörper im Betrieb ausgesandte Strahlung (gegebenenfalls durch geeignete Beschichtung der Innenwände der Ausnehmung 9) ausgebildet. Solche Grundgehäuse 8 werden insbesondere bei auf Leiterplatten oberflächenmontierbaren Leuchtdioden verwendet. Sie werden vor der Montage der Halbleiterkörper auf ein die elektrischen Anschlüsse 2, 3 aufweisendes Leiterband (Leadframe) zum Beispiel mittels Spritzgießen aufgebracht.

Die Ausnehmung 9 ist von einer Lumineszenzkonversionsschicht 4, beispielsweise eine separat hergestellte und auf dem Grundgehäuse 8 befestigte Abdeckplatte 17 aus Kunststoff, abgedeckt. Als geeignete Materialien für die Lumineszenzkonversionsschicht 4 kommen wiederum die weiter oben im allgemeinen Teil der Beschreibung genannten Kunststoffe oder anorganisches Glas in Verbindung mit den dort genannten Leuchtstoffen in Frage. Die Ausnehmung 9 kann sowohl mit einem transparenten Kunststoff, mit einem anorganischen Glas oder mit Gas gefüllt als auch mit einem Vakuum versehen sein.

Wie bei dem Ausführungsbeispiel nach Figur 2 kann auch hier zur besseren Auskopplung des Lichtes aus der Lumineszenzkonversionsschicht 4 auf dieser eine linsenförmige Abdeckung 29 (gestrichelt eingezeichnet) vorgesehen sein, die eine Totalreflexion der Strahlung innerhalb der Lumineszenzkonversionsschicht 4 reduziert. Diese Abdeckung 29 kann aus transparentem Kunststoff bestehen und auf die Lumineszenzkonversionsschicht 4 beispielsweise aufgeklebt oder zusammen mit der Lumineszenzkonversionsschicht 4 einstückig ausgebildet sein.

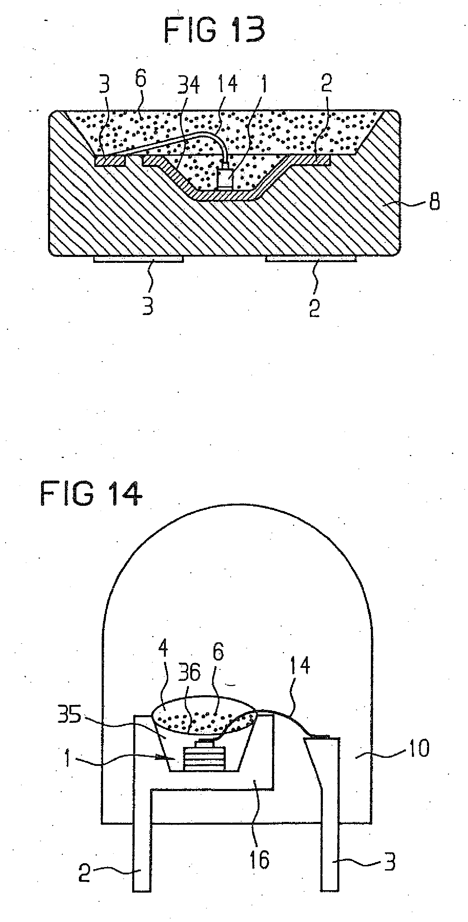

Bei einer nicht erfindungsgemäßen Abwandlung ist die Ausnehmung 9, wie in Figur 10 gezeigt, mit einem mit Leuchtstoff versehenen Epoxidharz, das heißt mit einer Lumineszenzumhüllung 5 gefüllt, die das Lumineszenzkonversionselement bildet. Eine Abdeckplatte 17 und/oder eine linsenförmige Abdeckung 29 kann dann auch weggelassen sein. Weiterhin ist optional, wie in Figur 13 dargestellt, der erste elektrische Anschluss 2 zum Beispiel durch Prägen im Bereich des Halbleiterkörpers 1 als Reflektorwanne 34 ausgebildet, die mit einer Lumineszenzkonversionsumhüllung 5 gefüllt ist.

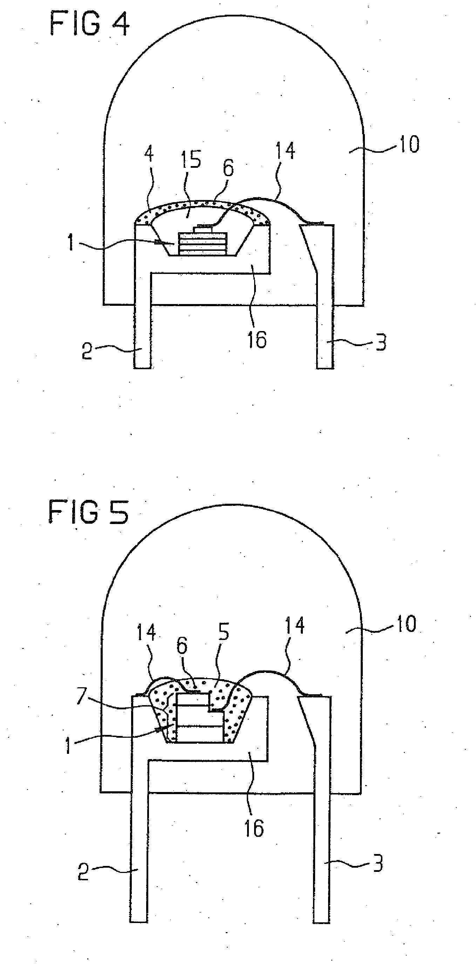

In Figur 4 ist als weiteres Ausführungsbeispiel eine so genannte Radialdiode dargestellt. Hierbei ist der Halbleiterkörper 1 in einem als Reflektor ausgebildeten Teil 16 des ersten elektrischen Anschlusses 2 beispielsweise mittels Löten oder Kleben befestigt. Derartige Gehäusebauformen sind in der Leuchtdiodentechnik bekannt und bedürfen von daher keiner näheren Erläuterung.

Bei dem Ausführungsbeispiel von Figur 4 ist der Halbleiterkörper 1 von einer transparenten Umhüllung 15 umgeben, die, wie beim zweitgenannten Ausführungsbeispiel (Figur 2), keine Wellenlängenänderung der von dem Halbleiterkörper 1 ausgesandten Strahlung bewirkt und beispielsweise aus einem herkömmlich in der Leuchtdiodentechnik verwendeten transparenten Epoxidharz oder aus organischem Glas bestehen kann.

Auf dieser transparenten Umhüllung 15 ist eine Lumineszenzkonversionsschicht 4 aufgebracht. Als Material hierfür kommen beispielsweise wiederum die im Zusammenhang mit den vorgenannten Ausführungsbeispielen angeführten Kunststoffe oder anorganisches Glas in Verbindung mit den dort genannten Farbstoffen in Frage.

Der gesamte Aufbau, bestehend aus Halbleiterkörper 1, Teilbereiche der elektrischen Anschlüsse 2, 3, transparente Umhüllung 15 und Lumineszenzkonversionsschicht 4, ist unmittelbar von einer weiteren transparenten Umhüllung 10 umschlossen, die keine Wellenlängenänderung der durch die Lumineszenzkonversionsschicht 4 hindurch getretenen Strahlung bewirkt. Sie besteht beispielsweise wiederum aus einem herkömmlich in der Leuchtdiodentechnik verwendeten transparenten Epoxidharz oder aus anorganischem Glas.

Die in Figur 5 gezeigte nicht erfindungsgemäße Abwandlung unterscheidet sich von dem von Figur 4 im Wesentlichen dadurch, dass die freien Oberflächen des Halbleiterkörpers 1 unmittelbar von einer Lumineszenzkonversionsumhüllung 5 bedeckt sind, die wiederum von einer weiteren transparenten Umhüllung 10 umgeben ist. In Figur 5 ist weiterhin beispielhaft ein Halbleiterkörper 1 dargestellt, bei dem anstelle des Unterseitenkontaktes ein weiterer Kontakt auf der Halbleiterschichtenfolge 7 angebracht ist, der mittels eines zweiten Bonddrahtes 14 mit dem zugehörigen elektrischen Anschluss 2 oder 3 verbunden ist. Selbstverständlich sind derartige Halbleiterkörper 1 auch bei allen anderen hierin beschriebenen Ausführungsbeispielen einsetzbar. Umgekehrt ist natürlich auch bei der Abwandlung von Figur 5 ein Halbleiterkörper 1 gemäß den vorgenannten Ausführungsbeispielen verwendbar.

Der Vollständigkeit halber sei an dieser Stelle angemerkt, dass selbstverständlich auch bei der Bauform nach Figur 5 analog zu Figur 1 eine einstückige Lumineszenzkonversionsumhüllung 5, die dann an die Stelle der Kombination aus Lumineszenzkonversionsumhüllung 5 und weiterer transparenter Umhüllung 10 tritt, verwendet sein kann.

Bei der nicht erfindungsgemäßen Abwandlung von Figur 6 ist eine Lumineszenzkonversionsschicht 4 (mögliche Materialien wie oben angegeben) direkt auf den Halbleiterkörper 1 aufgebracht. Dieser und Teilbereiche der elektrischen Anschlüsse 2, 3 sind von einer weiteren transparenten Umhüllung 10 umschlossen, die keine Wellenlängenänderung der durch die Lumineszenzkonversionsschicht 4 hindurch getretenen Strahlung bewirkt und beispielsweise aus einem in der Leuchtdiodentechnik verwendbaren transparenten Epoxidharz oder aus Glas gefertigt ist.

Solche, mit einer Lumineszenzkonversionsschicht 4 versehenen Halbleiterkörper 1 ohne Umhüllung können natürlich vorteilhafterweise in sämtlichen aus der Leuchtdiodentechnik bekannten Gehäusebauformen (zum Beispiel SMD-Gehäuse, Radial-Gehäuse (man vergleiche Figur 5)) verwendet sein.

Bei dem in Figur 14 dargestellten Ausführungsbeispiel eines erfindungsgemäßen Halbleiterbauelements ist auf dem Halbleiterkörper 1 ein transparentes Wannenteil 35 angeordnet, das über dem Halbleiterkörper 1 eine Wanne 36 aufweist. Das Wannenteil 35 besteht beispielsweise aus transparentem Epoxidharz oder aus anorganischem Glas und ist zum Beispiel mittels Umspritzen der elektrischen Anschlüsse 2, 3 einschließlich Halbleiterkörper 1 gefertigt. In dieser Wanne 36 ist eine Lumineszenzkonversionsschicht 4 angeordnet, die zum Beispiel wiederum aus Epoxidharz oder anorganischem Glas gefertigt ist, in das Partikel 37, bestehend aus einem der oben genannten anorganischen Leuchtstoffe, eingebunden sind. Bei dieser Bauform wird vorteilhafterweise auf sehr einfache Weise sichergestellt, dass sich der Leuchtstoff während der Herstellung des Halbleiterbauelements an nicht vorgesehenen Stellen, zum Beispiel neben dem Halbleiterkörper, ansammelt. Das Wannenteil 35 kann selbstverständlicherweise auch separat hergestellt und anderweitig, zum Beispiel an einem Gehäuseteil, über dem Halbleiterkörper 1 befestigt sein.

Bei sämtlichen der oben beschriebenen Ausführungsbeispiele kann zur Optimierung des Farbeindrucks des abgestrahlten Lichts sowie zur Anpassung der Abstrahlcharakteristik das Lumineszenzkonversionselement (Lumineszenzkonversionsumhüllung 5 oder Lumineszenzkonversionsschicht 4), gegebenenfalls die transparente Umhüllung 15, und/oder gegebenenfalls die weitere transparente Umhüllung 10 Licht streuende Partikel, vorteilhafterweise so genannte Diffusoren aufweisen. Beispiele für derartige Diffusoren sind mineralische Füllstoffe, insbesondere CaF₂, TiO₂, SiO₂, CaCO₃ oder BaSO₄ oder auch organische Pigmente. Diese Materialien können auf einfache Weise den oben genannten Kunststoffen zugesetzt werden.

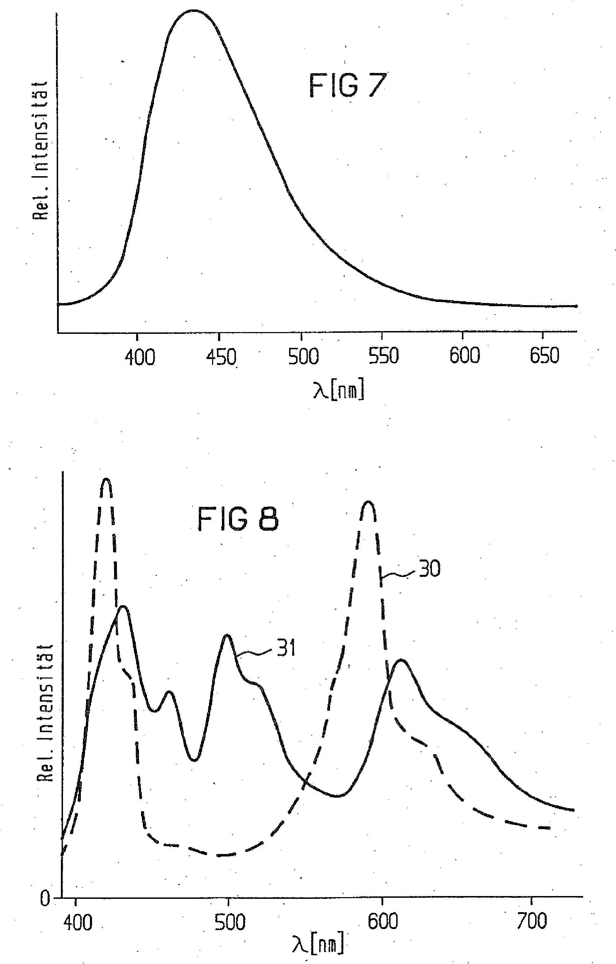

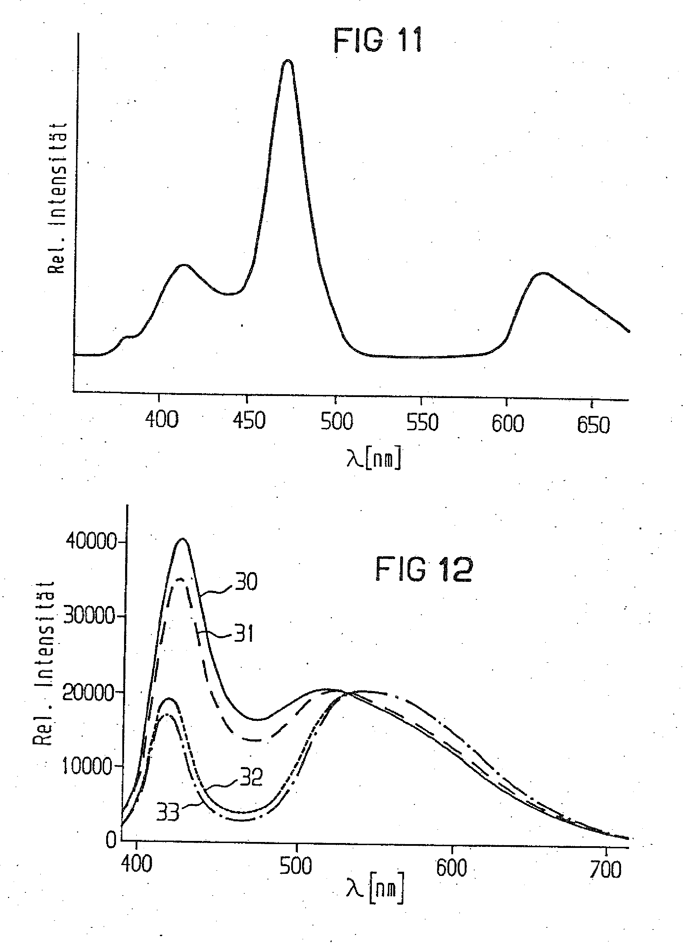

In den Figuren 7, 8 und 12 sind Emissionsspektren eines blaues Licht abstrahlenden Halbleiterkörpers (Figur 7) (Lumineszenzmaximum bei λ ∼ 430 nm) beziehungsweise von mittels eines solchen Halbleiterkörpers hergestellten weiß leuchtenden erfindungsgemäßen Halbleiterbauelementen (Figur 8 und 12) gezeigt. An der Abszisse ist jeweils die Wellenlänge λ in nm und auf der Ordinate ist jeweils eine relative Elektrolumineszenz(EL)-Intensität aufgetragen.

Von der vom Halbeiterkörper ausgesandten Strahlung nach Figur 7 wird nur ein Teil in einen längerwelligen Wellenlängenbereich konvertiert, so dass als Mischfarbe weißes Licht entsteht. Die gestrichelte Linie 30 in Figur 8 stellt ein Emissionsspektrum von einem erfindungsgemäßen Halbleiterbauelement dar, das Strahlung aus zwei komplementären Wellenlängenbereichen (Blau und Gelb) und damit insgesamt weißes Licht aussendet. Das Emissionsspektrum weist hier bei Wellenlängen zwischen zirka 400 und zirka 430 nm (Blau) und zwischen zirka 550 und zirka 580 nm (Gelb) je ein Maximum auf. Die durchgezogene Linie 31 repräsentiert das Emissionsspektrum eines erfindungsgemäßen Halbleiterbauelements, das die Farbe Weiß aus drei Wellenlängenbereichen (additives Farbtripel aus Blau, Grün und Rot) mischt. Das Emissionsspektrum weist hier beispielsweise bei den Wellenlängen von zirka 430 nm (Blau), zirka 500 nm (Grün) und zirka 615 nm (Rot) je ein Maximum auf.

Des Weiteren ist in Figur 11 ein Emissionsspektrum eines erfindungsgemäßen Halbleiterbauelements dargestellt, das mischfarbiges Licht aus blauem Licht (Maximum bei einer Wellenlänge von zirka 470 nm) und rotem Licht (Maximum bei einer Wellenlänge von zirka 620 nm) abstrahlt. Der Gesamtfarbeindruck des abgestrahlten Lichtes für das menschliche Auge ist Magenta. Das vom Halbleiterkörper abgestrahlte Emissionsspektrum entspricht hier wiederum dem von Figur 7.

Figur 12 zeigt ein weiß leuchtendes erfindungsgemäßes Halbleiterbauelement, das mit einem ein Emissions-Spektrum gemäß Figur 7 aussendenden Halbleiterkörper versehen ist und bei dem als Leuchtstoff YAG:Ce verwendet ist. Von der vom Halbeiterkörper ausgesandten Strahlung nach Figur 7 wird nur ein Teil in einen längerwelligen Wellenlängenbereich konvertiert, so dass als Mischfarbe weißes Licht entsteht. Die verschiedenartig gestrichelten Linien 30 bis 33 von Figur 8 stellen Emissionsspektren von erfindungsgemäßen Halbleiterbauelementen dar, bei denen das Lumineszenzkonversionselement, in diesem Fall eine Lumineszenzkonversionsumhüllung aus Epoxidharz, unterschiedliche YAG:Ce-Konzentrationen aufweist. Jedes Emissionsspektrum weist zwischen λ = 420 nm und λ = 430 nm, also im blauen Spektralbereich, und zwischen λ = 520 nm und λ = 545 nm, also im grünen Spektralbereich, jeweils ein Intensitätsmaximum auf, wobei die Emissionsbanden mit dem längerwelligen Intensitätsmaximum zu einem großen Teil im gelben Spektralbereich liegen. Das Diagramm von Figur 12 verdeutlicht, dass bei dem erfindungsgemäßen Halbleiterbauelement auf einfache Weise durch Veränderung der Leuchtstoffkonzentration im Epoxidharz der CIE-Farbort des weißen Lichtes verändert werden kann.

Weiterhin ist es möglich, anorganische Leuchtstoffe auf Basis von Ce-dotierten Granaten, Thiogallaten, Erdalkali-Sulfiden und Aluminaten direkt auf den Halbleiterkörper aufzubringen, ohne sie in Epoxidharz oder Glas zu dispergieren.

Ein weiterer besonderer Vorteil der oben genannten anorganischen Leuchtstoffe ergibt sich daraus, dass die Leuchtstoffkonzentration zum Beispiel im Epoxidharz nicht wie bei organischen Farbstoffen durch die Löslichkeit begrenzt wird. Dadurch sind keine großen Dicken von Lumineszenzkonversionselementen nötig.

Die Erläuterung des erfindungsgemäßen Halbleiterbauelements anhand der oben beschriebenen Ausführungsbeispiele ist natürlich nicht als Beschränkung der Erfindung auf diese zu betrachten. Als Halbleiterkörper, wie beispielsweise Leuchtdioden-Chips oder Laserdioden-Chips, ist beispielsweise auch eine Polymer-LED zu verstehen, die ein entsprechendes Strahlungsspektrum aussendet.

## Patentansprüche

1. Lichtabstrahlendes Halbleiterbauelement mit einem Halbleiterkörper (1), der eine Halbleiterschichtenfolge aufweist, die im Betrieb des Halbleiterbauelements elektromagnetische Strahlung eines ersten Wellenlängenbereichs aussendet, der Strahlung aus dem ultravioletten, blauen und/oder grünen Spektralbereich umfasst, und mit einem Lumineszenzkonversionselement, das mindestens einen Leuchtstoff aufweist,
wobei zumindest ein Teil der Oberfläche des Halbleiterkörpers (1) von einer strahlungsdurchlässigen Umhüllung umgeben ist und das Lumineszenzkonversionselement als Lumineszenzkonversionsschicht (4) ausgebildet ist, die über der strahlungsdurchlässigen Umhüllung (15) angeordnet ist,
wobei das Lumineszenzkonversionselement eine aus dem ersten Wellenlängenbereich stammende Strahlung der Halbleiterschichtenfolge in Strahlung eines vom ersten verschiedenen zweiten Wellenlängenbereiches umwandelt, derart, dass das Halbleiterbauelement mischfarbiges Licht aussendet, das Strahlung des ersten Wellenlängenbereichs und Strahlung des zweiten Wellenlängenbereichs umfasst,
**dadurch gekennzeichnet, dass**
das Lumineszenzkonversionselement anorganische Leuchtstoffpartikel enthält, die sich in dem sie umhüllenden Medium nicht lösen und wobei der Leuchtstoff einen von dem des umgebenden Mediums verschiedenen Brechungsindex aufweist, so dass eine Richtcharakteristik der von der Halbleiterschichtenfolge abgestrahlten elektromagnetischen Strahlung durch die anorganischen Leuchtstoffpartikel und/oder durch zusätzliche lichtstreuende Partikel abgeschwächt ist, so dass eine Farbhomogenität des mischfarbigen Lichts verbessert ist.

2. Lichtabstrahlendes Halbleiterbauelement nach einem der obigen Ansprüche, bei dem die strahlungsdurchlässige Umhüllung (15) eines der folgenden Materialien aufweist: Epoxidharz, Silikonharz, Acrylatharz, anorganisches Glas.

3. Lichtabstrahlendes Halbleiterbauelement nach einem der obigen Ansprüche, bei dem der Leuchtstoff aus der folgenden Gruppe gewählt ist: mit Seltenen Erden dotierten Granate, mit Seltenen Erden dotierten Erdalkali-Sulfide, mit Seltenen Erden dotierten Thiogallate, mit Seltenen Erden dotierten Aluminate, mit Seltenen Erden dotierten Orthosilikate.

4. Lichtabstrahlendes Halbleiterbauelement nach einem der obigen Ansprüche, bei dem der Leuchtstoff in einer Epoxidharz-Matrix oder einer Matrix aus Silikonmaterial oder einer Matrix aus einem niedrigschmelzenden anorganischen Glas eingebettet ist.

5. Lichtabstrahlendes Halbleiterbauelement nach einem der obigen Ansprüche, bei dem der erste Wellenlängenbereich und der zweite Wellenlängenbereich der Mischstrahlung zumindest teilweise in zueinander komplementärfarbigen Spektralbereichen liegen, so dass weißes Licht erzeugt wird.

6. Lichtabstrahlendes Halbleiterbauelement nach einem der Ansprüche 1 bis 4, bei dem das Lumineszenzkonversionselement Strahlung des ersten Wellenlängenbereichs in Strahlung mehrerer zweiter Wellenlängenbereiche aus voneinander verschiedenen spektralen Teilbereichen umwandelt, derart, dass das Halbleiterbauelement Mischstrahlung, bestehend aus Strahlung des ersten Wellenlängenbereiches und Strahlung der zweiten Wellenlängenbereiche aussendet.

7. Lichtabstrahlendes Halbleiterbauelement nach dem vorherigen Anspruch, bei dem der vom Halbleiterkörper (1) ausgesandte erste Wellenlängenbereich und zwei zweite Wellenlängenbereiche ein additives Farbtripel ergeben, derart, dass in Betrieb des Halbleiterbauelements von diesem weißes Licht abgestrahlt wird.

8. Lichtabstrahlendes Halbleiterbauelement nach einem der obigen Ansprüche, bei dem das Lumineszenzkonversionselement mehrere Schichten mit unterschiedlichen Wellenlängenkonversionseigenschaften aufweist.

9. Lichtabstrahlendes Halbleiterbauelement nach einem der obigen Ansprüche, **dadurch gekennzeichnet, dass** das Lumineszenzkonversionselement und/oder die transparente Umhüllung (15) lichtstreuende Partikel aufweist.

10. Lichtabstrahlendes Halbleiterbauelement nach einem der obigen Ansprüche, bei dem der Halbleiterkörper (1) in einer Ausnehmung (9) eines lichtundurchlässigen Grundgehäuses (8) angeordnet und die Ausnehmung (9) mit einer die Lumineszenzkonversionsschicht (4) aufweisenden Abdeckschicht versehen ist.

11. Lichtabstrahlendes Halbleiterbauelement nach einem der obigen Ansprüche, bei dem der Halbleiterkörper (1) im Betrieb des Halbleiterbauelements ultraviolette Strahlung aussendet und das Lumineszenzkonversionselement zumindest einen Teil dieser ultravioletten Strahlung in sichtbares Licht umwandelt.

12. Beleuchtungseinrichtung zur Beleuchtung einer Anzeigevorrichtung, insbesondere einer Flüssigkristallanzeige, mit einem lichtabstrahlenden Halbleiterbauelement gemäß einem der Ansprüche 1 bis 11.

## Claims

1. Light emitting semiconductor component having a semiconductor body (1), which has a semiconductor layer sequence, which emits electromagnetic radiation of a first wavelength range which comprises radiation from the ultraviolet, blue and/or green spectral range during operation of the semiconductor component, and having a luminescence conversion element which comprises at least one luminescent material, wherein at least one part of the surface of the semiconductor body (1) is surrounded by a radiation-transmissive encapsulation and the luminescence conversion element is embodied as a luminescence conversion layer (4) arranged above the radiation-transmissive encapsulation (15), wherein the luminescence conversion element converts a radiation of the semiconductor layer sequence originating from the first wavelength range into radiation of a second wavelength range, which differs from the first wavelength range, in such a way that the semiconductor component emits mixed-coloured light which comprises radiation of the first wavelength range and radiation of the second wavelength range, **characterized in that** the luminescence conversion element comprises inorganic luminescent material particles which do not dissolve in the medium encapsulating them, and wherein the luminescent material has a different refractive index from that of the surrounding medium, such that a directional characteristic of the electromagnetic radiation emitted by the semiconductor layer sequence is attenuated by the inorganic luminescent material particles and/or by additional light-diffusing particles, such that a colour homogeneity of the mixed-coloured light is improved.

2. Light emitting semiconductor component according to Claim 1, wherein the radiation-transmissive encapsulation (15) comprises one of the following materials: epoxy resin, silicone resin, acrylate resin, inorganic glass.

3. Light emitting semiconductor component according to either of the preceding claims, wherein the luminescent material is chosen from the following group: garnets doped with rare earths, alkaline earth metal sulphides doped with rare earths, thiogallates doped with rare earths, aluminates doped with rare earths, orthosilicates doped with rare earths.

4. Light emitting semiconductor component according to one of the preceding claims, wherein the luminescent material is embedded in an epoxy resin matrix or a matrix made of silicone material or a matrix made of an inorganic glass of low melting point.

5. Light emitting semiconductor component according to one of the preceding claims, wherein the first wavelength range and the second wavelength range of the mixed radiation lie at least partly in spectral ranges of mutually complementary colours, such that white light is generated.

6. Light emitting semiconductor component according to one of Claims 1 to 4, in which the luminescence conversion element converts radiation of the first wavelength range into radiation of a plurality of second wavelength ranges from mutually different spectral subregions, in such a way that the semiconductor component emits mixed radiation, comprising radiation of the first wavelength range and radiation of the second wavelength ranges.

7. Light emitting semiconductor component according to the preceding claim, in which the first wavelength range emitted by the semiconductor body (1) and two second wavelength ranges produce an additive colour triad, in such a way that white light is emitted by the semiconductor component during operation thereof.

8. Light emitting semiconductor component according to one of the preceding claims, wherein the luminescence conversion element has a plurality of layers having different wavelength conversion properties.

9. Light emitting semiconductor component according to one of the preceding claims, **characterized in that** the luminescence conversion element and/or the transparent encapsulation (15) have/has light-diffusing particles.

10. Light emitting semiconductor component according to one of the preceding claims, in which the semiconductor body (1) is arranged in a recess (9) of an opaque base housing (8) and the recess (9) is provided with a covering layer having the luminescence conversion layer (4).

11. Light emitting semiconductor component according to one of the preceding claims, wherein the semiconductor body (1) emits ultraviolet radiation during the operation of the semiconductor component and the luminescence conversion element converts at least part of said ultraviolet radiation into visible light.

12. Illumination device for the illumination of a display device, in particular of a liquid crystal display, having a light emitting semiconductor component according to one of Claims 1 to 11.

## Revendications

1. Elément semi-conducteur luminescent avec un corps semi-conducteur (1), qui présente une suite de couches semi-conductrices, laquelle lors du fonctionnement de l'élément semi-conducteur émet un rayonnement électromagnétique d'une première plage de longueur d'onde, qui comprend un rayonnement de la plage spectrale ultraviolette, bleue et/ou verte, et avec un élément de conversion de luminescence, qui présente au moins une substance luminescente, dans lequel au moins une partie de la surface du corps semi-conducteur (1) est entourée par une enveloppe laissant passer le rayonnement et l'élément de conversion de luminescence est conçu comme une couche de conversion de luminescence (4), qui est disposée par-dessus l'enveloppe (15) laissant passer le rayonnement, dans lequel l'élément de conversion de luminescence convertit un rayonnement provenant de la première plage de longueur d'onde de la suite de couches semi-conductrices en rayonnement d'une deuxième plage de longueur d'onde différente de la première, de telle sorte que l'élément semi-conducteur émette une lumière à couleur mélangée, qui comprend un rayonnement de la première plage de longueur d'onde et un rayonnement de la deuxième plage de longueur d'onde, **caractérisé en ce que** l'élément de conversion de luminescence contient des particules de substance luminescente inorganiques, qui ne se dissolvent pas dans le milieu les enveloppant et dans lequel la substance luminescente présente un index de réfraction différent de celui du milieu enveloppant, de telle sorte que la directivité du rayonnement électromagnétique émis par la suite de couches semi-conductrices est atténuée par les particules de substance luminescente inorganiques et/ou par des particules supplémentaires de diffusion de lumière, de telle sorte qu'une homogénéité de couleur de la lumière à couleur mélangée soit améliorée.

2. Elément semi-conducteur luminescent selon la revendication 1, dans lequel l'enveloppe laissant passer le rayonnement (15) présente un des matériaux suivants : résine époxy, résine silicone, résine acrylate, verre inorganique.

3. Elément semi-conducteur luminescent selon une des revendications précédentes, dans lequel la substance luminescente est sélectionnée dans le groupe suivant : des grenats dopés aux terres rares, des sulfites alcalino-terreux dopés aux terres rares, des thiogallates dopés aux terres rares, des aluminates dopés aux terres rares, des orthosilicates dopés aux terres rares.

4. Elément semi-conducteur luminescent selon une des revendications précédentes, dans lequel la substance luminescente est noyée dans une matrice de résine époxy ou une matrice en matière de silicone ou une matrice en verre inorganique fondant à basse température.

5. Elément semi-conducteur luminescent selon une des revendications précédentes, dans lequel la première plage de longueur d'onde et la deuxième plage de longueur d'onde du rayonnement mixte se situent au moins partiellement dans des plages spectrales de couleurs complémentaires les unes des autres, de sorte qu'une lumière blanche soit générée.

6. Elément semi-conducteur luminescent selon une des revendications 1 à 4, dans lequel l'élément de conversion de luminescence convertit un rayonnement de la première plage de longueur d'onde en rayonnement de plusieurs deuxièmes plages de longueur d'onde composées de zones partielles spectrales différentes les unes des autres, de telle sorte que l'élément semi-conducteur émette un rayonnement mixte, constitué du rayonnement de la première plage de longueur d'onde et du rayonnement des deuxièmes plages de longueur d'onde.

7. Elément semi-conducteur luminescent selon la revendication précédente, dans lequel la première plage de longueur d'onde émise par le corps semi-conducteur (1) et deux deuxièmes plages de longueur d'onde produisent une triade de couleurs additive, de telle sorte que, lors du fonctionnement de l'élément semi-conducteur, de la lumière blanche soit émise par celui-ci.

8. Elément semi-conducteur luminescent selon une des revendications précédentes, dans lequel l'élément de conversion de luminescence présente plusieurs couches avec différentes propriétés de conversion de longueur d'onde.

9. Elément semi-conducteur luminescent selon une des revendications précédentes, **caractérisé en ce que** l'élément de conversion de luminescence et/ou l'enveloppe transparente (15) présente(nt) des particules de diffusion de lumière.

10. Elément semi-conducteur luminescent selon une des revendications précédentes, dans lequel le corps semi-conducteur (1) est disposé dans un évidement (9) d'un boîtier de base (8) ne laissant pas passer la lumière et l'évidement (9) est muni d'une couche de recouvrement présentant la couche de conversion de luminescence (4).

11. Elément semi-conducteur luminescent selon une des revendications précédentes, dans lequel le corps semi-conducteur (1) lors du fonctionnement de l'élément semi-conducteur émet un rayonnement ultraviolet et l'élément de conversion de luminescence convertit au moins une partie de ce rayonnement ultraviolet en lumière visible.

12. Dispositif d'éclairage pour éclairer un dispositif d'affichage, notamment un écran à cristaux liquides, comportant un élément semi-conducteur luminescent selon une des revendications 1 à 11.
